# FASCICULE DE BREVET EUROPEEN

(11) **EP 2 801 108 B1**
(45) Date de publication et mention de la délivrance du brevet: **24.02.2016**
(21) Numéro de dépôt: 12809290.5
(22) Date de dépôt: 28.12.2012
(51) Int. Cl.: H01L 21/677, B65G 53/00, B05D 3/02

(54) **PROCEDE DE TRANSFERT D'OBJETS SUR UN SUBSTRAT A L'AIDE D'UN FILM COMPACT DE PARTICULES**
VERFAHREN ZUR ÜBERTRAGUNG VON GEGENSTÄNDEN AUF EIN SUBSTRAT DURCH EINEN KOMPAKTEN PARTIKELFILM
METHOD FOR TRANSFERRING OBJECTS ONTO A SUBSTRATE BY MEANS OF A COMPACT FILM OF PARTICLES

(30) Priorité: 02.01.2012 FR 1250028
(43) Date de publication de la demande: 12.11.2014
(73) Titulaire: Commissariat à l'Énergie Atomique et aux Énergies Alternatives, 75015 Paris (FR)
(72) Inventeur: DELLEA, Olivier, F-42350 La Talaudière (FR); CORONEL, Philippe, F-38350 Barraux (FR); FUGIER, Pascal, F-38190 Bernin (FR)
(74) Mandataire: Brevalex
(86) Numéro de dépôt international: PCT/EP2012/077052
(87) Numéro de publication internationale: WO 2013/102608

(56) Documents cités:
- EP-A1- 2 355 145
- CA-A1- 2 695 449

## Description

### DOMAINE TECHNIQUE

L'invention se rapporte au domaine du transfert d'objets sur un substrat, de préférence en défilement, afin de fabriquer des dispositifs variés.

Il s'agit en particulier de fabriquer des dispositifs à caractère hybride, comme par exemple des capteurs. A titre indicatif, un dispositif hybride associe par définition sur un même substrat des objets ayant diverses fonctions, par exemple électroniques, optiques, électro-optiques, piézo-électriques, thermoélectriques, mécaniques, etc.

Les objets à déposer/transférer sont par exemple :
- des composants électroniques actifs, tels que des transistors, microprocesseurs, circuits intégrés, etc. ;
- des composants passifs de l'électronique, comme des résistances, capacités, diodes, photodiodes, bobines, pistes conductrices, préformes de soudure, etc. ;
- des composants optiques, tels que des lentilles, microlentilles, réseaux de diffraction, filtres, etc. ;
- des piles, micro-piles, micro-batteries, photo-détecteurs, cellules solaires, système RFID, etc. ;
- des particules ou agrégats nano ou micrométriques, actifs ou passifs, par exemple du type oxydes, polymères, métaux, semi-conducteurs, Janus, nanotubes, etc.

Plus particulièrement, l'invention concerne le transfert d'objets dont les dimensions s'étendent :
- pour les composants : de l'échelle microscopique (quelques dizaines de microns), à l'échelle macroscopique (plus d'une dizaine de centimètres) ; et
- pour les particules et agrégats : du nanomètre à plusieurs centaines de microns.

### ÉTAT DE LA TECHNIQUE ANTÉRIEURE

Dans le domaine industriel, la problématique du transfert/dépôt d'objets sur un substrat est généralement résolue par l'utilisation de la technique appelée *« pick and place »,* qui consiste à prendre les objets un par un avec un outil de préhension adapté, et à les placer précisément sur le substrat. Cette technique est cependant perfectible, notamment en ce sens qu'il est souvent difficile, voire impossible, de déplacer un objet une fois que celui-ci a été déposé sur le substrat. En cas d'erreur de manipulation, l'objet peut alors rester collé sur le substrat dans une mauvaise position.

EP 2355145 décrit un procédé de transfert d'objets sur un substrat.

### EXPOSÉ DE L'INVENTION

L'invention a donc pour but de remédier au moins partiellement aux inconvénients mentionnés ci-dessus, relatifs aux réalisations de l'art antérieur.

Pour ce faire, l'invention a pour objet un procédé de transfert d'objets sur un substrat, de préférence en défilement, à l'aide d'une zone de transfert comprenant une entrée et une sortie espacées l'une de l'autre par deux rebords latéraux en regard, et retenant un liquide porteur formant convoyeur, lesdits objets étant maintenus par un film compact de particules flottant sur le liquide porteur de cette zone de transfert, au sein de laquelle lesdits objets sont déplacés avec ledit film de particules de manière à être transférés sur le substrat lorsqu'ils atteignent la sortie.

L'invention est ainsi remarquable en ce qu'elle repose sur l'utilisation d'un film compact de particules pour maintenir en position les objets sur le liquide porteur, puis pour convoyer ces mêmes objets jusqu'au substrat. Le transfert des objets peut par conséquent s'effectuer avec précision sur le substrat, de manière simple, fiable, et répétitive. De plus, le dépôt des objets ne s'effectuant pas directement sur le substrat, il est facilement possible de réajuster leur position dans la zone de transfert, avant leur dépôt sur ce même substrat.

Le film compact de particules s'apparente donc à une plate-forme permettant d'accueillir des objets homogènes ou hétérogènes, nanoscopiques, microscopiques ou macroscopiques. Cette plate-forme peut elle-même être composée d'un ensemble homogène ou hétérogène de particules nanométriques ou microscopiques, de préférence de compositions différentes de celles des objets à transférer. Comme cela sera détaillé ci-après, les objets à transférer peuvent être intégrés à cette plate-forme, ou simplement être agencés sur celle-ci.

En effet, selon une première possibilité, au moins l'un des objets à transférer est placé dans la zone de transfert, en flottaison sur le liquide porteur formant convoyeur, de manière à être entouré par le film compact de particules. Ici, les objets sont maintenus en position par les particules qui les enserrent à leur périphérie. Les objets présentent ainsi une surface inférieure directement en contact avec le liquide porteur.

Selon une seconde possibilité, au moins l'un des objets à transférer est placé dans la zone de transfert sur le film compact de particules préalablement formé, de manière à créer, dans le liquide porteur, un enfoncement des particules qui le supportent.

Dans cette seconde solution, les particules enfoncées situées sous chaque objet définissent alors une rupture de niveau avec les particules environnantes du film. Ce sont alors ces mêmes particules environnantes qui enserrent la périphérie de chaque objet, permettant ainsi de les maintenir en position et de les transporter d'une façon analogue à celle de la première solution.

Bien entendu, des objets peuvent être placés dans le film de particules selon la première solution et d'autres selon la seconde solution, sans sortir du cadre de l'invention.

De plus, comme évoqué ci-dessus, le film compact de particules peut être formé de particules hétérogènes. Ces particules peuvent aussi être fonctionnalisées à leur surface pour que se forme un lien physique entre particules, par exemple de type polymère, afin de renforcer la cohésion et donc la portance du film compact.

De préférence, le rapport entre la grande dimension des particules du film compact et celle des objets à transférer est compris entre 10⁴ et 10⁸. A titre d'exemple, les particules formant le film compact peuvent présenter une grande dimension de l'ordre de 1 nm à 500 µm, tandis que les objets convoyés par ce film peuvent quant à eux présenter une grande dimension allant jusqu'à environ 30 cm.

De préférence, les particules du film compact sont des billes de silice d'environ 1 µm de diamètre. II est néanmoins noté que le film peut être hétérogène, à savoir comporter des billes de tailles différentes.

De préférence, chaque objet à transférer présente une grande dimension supérieure à 0,2 cm, et de préférence inférieure à 30 cm. Cette dernière valeur peut être adaptée en fonction de la largeur de la zone de transfert. En effet, la grande dimension de chaque objet peut atteindre une valeur proche de la largeur précitée. Des objets de taille micrométrique ou nanométrique peuvent également être déposés/transférés, sans sortir du cadre de l'invention.

De préférence, chaque objet à transférer présente au moins une partie à caractère hydrophobe. Cela est prévu de manière à assurer la flottaison de l'objet, en plaçant cette partie au contact du liquide porteur. Cette face de contact avec le liquide peut être totalement hydrophobe ou comporter un agencement de zones hydrophiles et hydrophobes, utiles au dispositif final.

L'objet à transférer peut être de toute forme, non-nécessairement plane, éventuellement présentant un ou plusieurs rayons de courbure, par exemple inférieur à 5 cm, ou encore intégrant des plots utiles pour la connectique. De même, pour les particules du film, les formes peuvent être variées.

A titre d'exemples indicatifs, chaque objet à transférer peut être un élément pris parmi le groupe des puces en silicium, des micro-batteries, des composants de l'électronique organique, des éléments métalliques, des cellules photovoltaïques, des piles et micro-piles.

II est également visé la fabrication de dispositifs complexes comme par exemple des capteurs comprenant des éléments de détections (des particules par exemple), un ou plusieurs systèmes de récupération d'énergie (cellule PV, film piézoélectrique, pile à combustible), un système de stockage de l'énergie (micro-batterie), un système de gestion de l'information (puce en Silicium), un système de communication (puce RFID), des éléments de liaison électrique (pistes conductrices), des composants électroniques (résistances, condensateurs), des éléments de soudure (préformes). Les objets nécessaires à l'obtention de ces dispositifs sont alors agencés en conséquence sur le convoyeur liquide, et étant au besoin superposés.

Il est par ailleurs noté que le film compact de particules, dont le concept est par exemple divulgué dans le document Sachin Kinge, "Self-Assembling Nanoparticles at Surfaces and Interfaces", ChemPhysChem 2008, 9, 20-42*,* peut être obtenu à la surface du liquide porteur par toute technique connue de l'homme du métier, par exemple par compression, et/ou interaction dipôle-dipôle, et/ou par champ magnétique, etc.

La technique par interaction dipôle-dipôle s'applique pour les particules à facettes, par exemple tétraédriques, cubiques ou encore octaédriques. Avec ces formes, les interactions dipôle-dipôle jouent un rôle important dans l'organisation des particules. Les moments dipolaires sont générés à l'intérieur de ces particules, à cause des différences de polarité entre les facettes.

La technique d'organisation par champ magnétique est employée avec des nanoparticules magnétiques pouvant être ordonnées en utilisant un champ magnétique intense, générant des interactions fortes entre les particules.

La technique par compression est notamment connue du document Lucio Isa et al., "Particle Lithography from Colloidal Self-Assembly at Liquid Liquid Interfaces", acsnano, VOL. 4 ▪ NO. 10 ▪ 5665-5670 ▪ 2010*,* du document Markus Retsch, « Fabrication of Large-Area, Transferable Colloidal Monolayers Utilizing Self-Assembly at the Air/Water Interface", Macromol. Chem. Phys. 2009, 210, 230-241*,* ou encore du document Maria Bardosova, « The Langmuir-Blodgett Approach to Making Colloidal Photonic Crystals from Silica Spheres", Adv. Mater. 2010, 22, 3104-3124*.*

Cette technique par compression comprend également la solution à rampe inclinée décrite dans le document CA 2 695 449. Ainsi, le procédé selon l'invention met préférentiellement en oeuvre une rampe inclinée de circulation des particules, rattachée à ladite entrée de la zone de transfert, et sur laquelle ledit liquide porteur est également destiné à circuler.

Une partie de l'énergie nécessaire à l'ordonnancement des particules en régime normal est alors ici amenée par la rampe inclinée transportant le liquide porteur et les particules. D'autres solutions sont néanmoins possibles, comme la mise en mouvement, à l'aide d'une pompe, du liquide porteur sur un plan horizontal dont la partie aval constitue la zone de transfert des particules. Une autre solution consiste à remplacer la pompe par une soufflerie permettant d'appliquer un flux d'air à la surface du liquide porteur, sur lequel flottent les particules et les objets à transférer. Comme mentionné ci-dessus, d'autres solutions sont néanmoins envisageables, sans sortir du cadre de l'invention, comme un travail de compression des particules via une technique dite « Langmuir-Blodgett ».

Enfin, postérieurement au transfert des particules et des objets sur le substrat, le procédé intègre de préférence une étape de recuit thermique pour faciliter le dépôt et l'adhérence de ces particules et objets sur le substrat.

D'autres avantages et caractéristiques de l'invention apparaîtront dans la description détaillée non limitative ci-dessous.

### BRÈVE DESCRIPTION DES DESSINS

Cette description sera faite au regard des dessins annexés parmi lesquels ;
- la figure 1 montre une installation de transfert selon un mode de réalisation préféré de la présente invention, en coupe schématique prise le long de la lign I-I de la figure 2 ;
- la figure 2 représente une vue schématique de dessus de l'instillation de transfert montrée sur la figure 1 ;
- les figures 3 à 7 représentent différentes étapes d'un procédé de transfert mis en oeuvre à l'aide de l'installation montrée sur les figures précédentes ;
- les figures 8 et 9 représentent différentes étapes d'un autre procédé de transfert, également mis en oeuvre à l'aide de l'installation montrée sur les figures 1 et 2;
- la figure 10 représente une installation de transfert selon un autre mode de réalisation préféré de la présente invention ; et
- les figures 11a à 11e montrent différentes solutions pour la mise en place des objets dans la zone de transfert.

### EXPOSÉ DÉTAILLÉ DE MODES DE RÉALISATION PRÉFÉRÉS

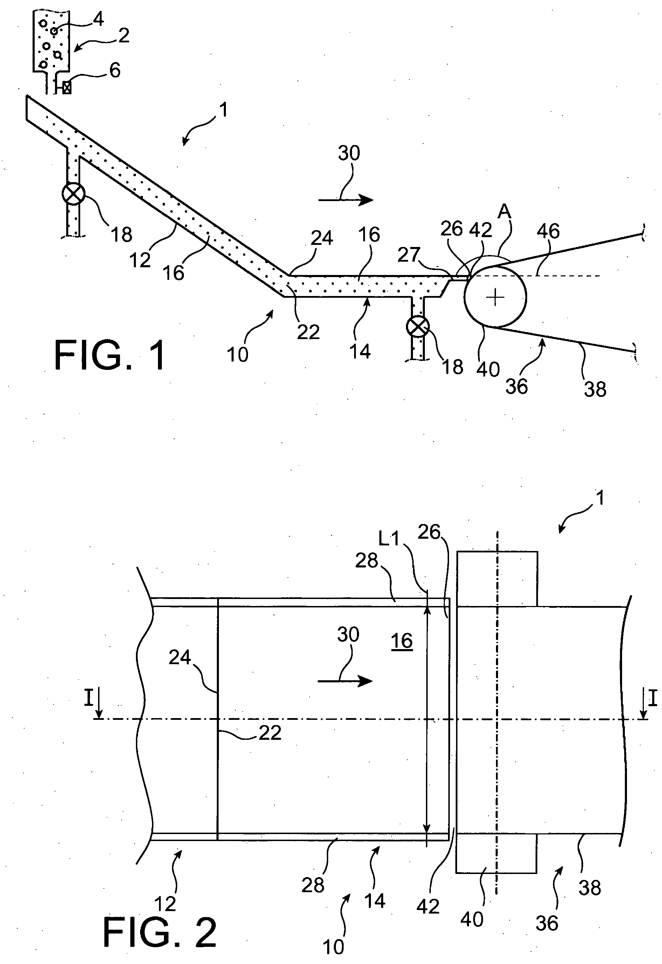

En référence tout d'abord aux figures 1 et 2, on peut apercevoir une installation 1 pour le transfert d'objets sur un substrat, de préférence en défilement. Ce transfert, assimilable à un dépôt, s'effectue à l'aide d'un film compact de particules.

L'installation 1 comporte un dispositif 2 de dispense de particules 4, dont la taille peut être comprise entre quelques nanomètres et plusieurs centaines de micromètres. Les particules, de préférence de forme sphérique, peuvent par exemple être des particules de silice. D'autres particules d'intérêt peuvent être faites de métal ou d'oxyde de métal comme le Platine, le TiO2, de polymère comme le polystyrène ou le PMMA, de carbone, etc.

Plus précisément, dans le mode de réalisation préféré, les particules sont des sphères de silice d'environ 1 µm de diamètre, stockées en solution dans le dispositif de dispense 2. La proportion du milieu est d'environ 7 g de particules pour 200 ml de solution, ici du butanol. Naturellement, pour des raisons de clarté, les particules représentées sur les figures adoptent un diamètre supérieur à leur diamètre réel.

Le dispositif de dispense 2 présente une buse d'injection 6 commandable, d'environ 500 µm de diamètre.

L'installation comporte également un convoyeur liquide 10, intégrant une rampe inclinée 12 de circulation des particules, et une zone de transfert 14 sensiblement horizontale, voire présentant une légère inclinaison de façon à favoriser la vidange de l'installation, le cas échéant. L'extrémité haute de la rampe inclinée est prévue pour recevoir les particules injectées depuis le dispositif de dispense 2. Cette rampe est droite, inclinée d'un angle compris entre 5 et 60°, de préférence entre 10 et 30°, permettant aux particules d'être acheminées vers la zone de transfert 14. De plus, un liquide porteur 16 circule sur cette rampe 12, jusque dans la zone de transfert. Ce liquide 16 peut d'ailleurs être re-circulé à l'aide d'une ou deux pompes 18, entre la zone de transfert 14 et l'extrémité haute de la rampe. Il s'agit ici de préférence d'une eau dé-ionisée, sur laquelle les particules 4 peuvent flotter. Néanmoins, on peut privilégier un liquide neuf via un circuit de circulation ouvert. Il peut aussi s'agir d'une association de plusieurs liquides non-miscibles.

L'extrémité basse de cette même rampe est raccordée à une entrée de la zone de transfert de particules 14. Cette entrée 22 se situe au niveau d'une ligne d'inflexion 24 matérialisant la jonction entre la surface du liquide porteur présent sur le plan incliné de la rampe 12, et la surface du liquide porteur présent sur la partie horizontale de la zone de transfert 14.

L'entrée de particules 22 est espacée d'une sortie de particules 26 à l'aide de deux rebords latéraux 28 retenant le liquide porteur 16 dans la zone 14. Ces rebords 28, en regard et à distance l'un de l'autre, s'étendent parallèlement à une direction principale d'écoulement du liquide porteur et des particules dans l'installation, cette direction étant schématisée par la flèche 30 sur les figures 1 et 2. La zone 14 prend par conséquent la forme d'un couloir ou d'un chemin ouvert à son entrée et à sa sortie, même si d'autres géométries pourraient être adoptées, sans sortir du cadre de l'invention.

Le fond de la partie aval de la zone de transfert présente un plateau 27 légèrement incliné vers l'amont par rapport à la direction horizontale, par exemple d'une valeur de l'ordre de 5 à 10°. C'est l'extrémité aval de ce même plateau 27, également dénommé « blade », qui définit en partie la sortie des particules 26.

L'installation 1 est également pourvue d'un convoyeur de substrat 36, destiné à mettre le substrat 38 en défilement. Ce substrat peut être rigide ou souple. Dans ce dernier cas, il peut être mis en mouvement sur un rouleau 40 dont l'axe est parallèle à la sortie 26 de la zone 14, à proximité de laquelle il se situe. En effet, le substrat 38 est destiné à défiler de manière très rapprochée de la sortie 26, afin que les particules atteignant cette sortie puisse être transférées aisément sur ce substrat, via un pont capillaire 42, également dénommé ménisque, qui le relie au liquide porteur 16. Alternativement, le substrat peut être au contact directement de la zone de transfert, sans sortir du cadre de l'invention. Le pont capillaire mentionné ci-dessus n'est alors plus requis.

Dans l'exemple montré sur les figures, la largeur du substrat correspond à la largeur de la zone 14 et de sa sortie 26. Il s'agit d'une largeur L1 qui correspond aussi à la largeur maximale du film de particules qu'il est possible de déposer sur le substrat. Cette largeur peut être de l'ordre de 25 à 30 cm. La largeur du substrat sur lequel doivent être déposées les particules peut cependant être inférieure à la largeur L1.

Le pont capillaire 42 est assuré entre le liquide porteur 16 qui se situe au niveau de la sortie 26, et une partie du substrat 38 épousant le rouleau de guidage / d'entraînement 40.

De préférence, l'angle saillant A, formé entre la direction horizontale 46 et la partie du substrat 38 sur laquelle le film de particules et les objets doivent se déposer, est supérieure à 160°, et encore plus préférentiellement proche de 180°, par exemple de l'ordre de 175°.

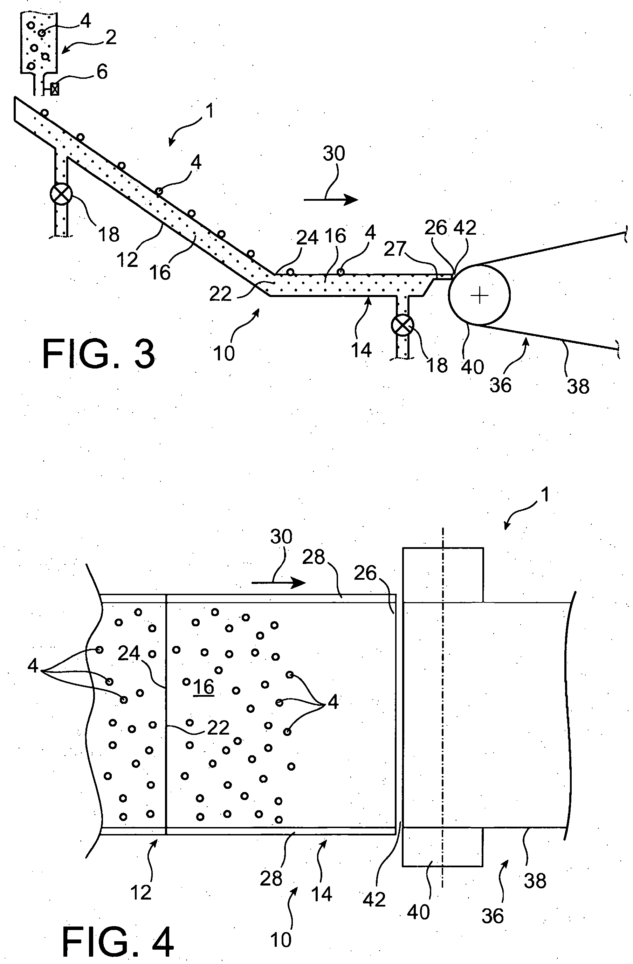

Un procédé de transfert d'objets va maintenant être décrit en référence aux figures 3 à 7.

Tout d'abord, la buse d'injection 6 est activée pour débuter la dispense des particules 4 sur la rampe 12. Il s'agit de mettre en oeuvre une étape initiale de remplissage de la zone de transfert 14, par les particules 4, avec le liquide porteur 16 déjà au niveau requis dans la zone 14.

Durant cette phase d'amorçage, les particules dispensées par le dispositif 2 circulent sur la rampe 12, puis pénètrent dans la zone 14 dans laquelle elles se dispersent, comme cela a été schématisé sur les figures 3 et 4.

Au fur et à mesure que les particules 4 sont injectées sur la rampe 12 et pénètrent dans la zone de transfert 14, elles viennent en butée contre le substrat 38, puis le front amont de ces particules a tendance à se décaler vers l'amont, en direction de la ligne d'inflexion 24. L'injection de particules est poursuivie même après que ce front amont ait dépassé la ligne 24, afin qu'il remonte sur la rampe inclinée 12.

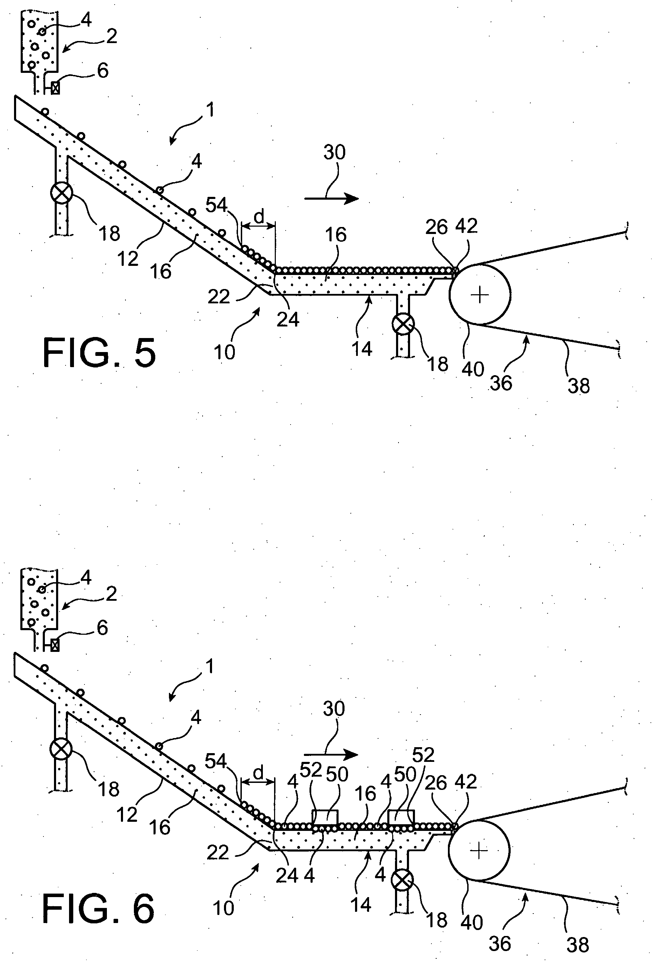

Effectivement, il est fait en sorte que le front amont de particules 54 remonte sur la rampe 12 de manière à ce qu'il se situe à une distance horizontale « d » donnée de la ligne d'inflexion 24, comme montré sur la figure 5. La distance « d » peut être de l'ordre de 30 mm.

A cet instant, les particules 4 sont ordonnées dans la zone de transfert et sur la rampe 12, sur laquelle elles s'ordonnent automatiquement, sans assistance, grâce notamment à leur énergie cinétique mise à profit au moment de l'impact sur le front 54. L'ordonnancement est tel que le film compact obtenu présente une structure dite « hexagonale compacte », dans laquelle chaque particule 4 est entourée et contactée par six autres particules 4 en contact entre elles. Il est alors indifféremment parlé de film compact de particules, ou de film de particules ordonnées.

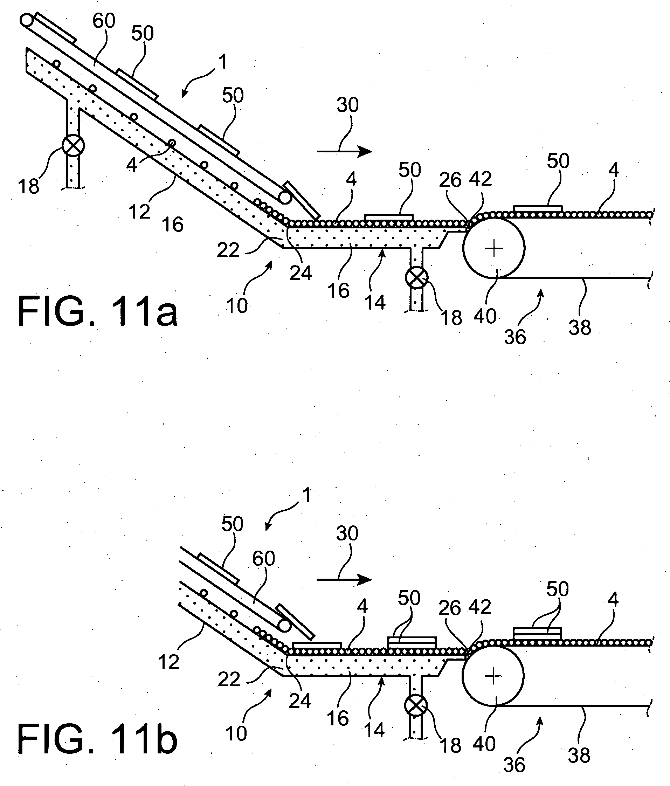

Une fois que les particules ordonnancées 4 recouvrent l'intégralité du liquide porteur situé dans la zone de transfert 14, les objets 50 à déposer/transférer peuvent être mis en place au-dessus du film, à des emplacements prédéterminés. Cette mise en place peut être réalisée à l'aide d'outils de manipulation ou de préhension conventionnels adaptés à la nature, la forme et la dimension des objets, comme des pinces. D'autres solutions sont envisagées, comme celle qui sera décrite ultérieurement en référence aux figures 11a à 11e.

Comme le montre la figure 6, le positionnement des objets 50 sur le film a pour conséquence de créer un enfoncement des particules 4 qui supportent ces mêmes objets, dans le liquide porteur 16 formant convoyeur. Il est noté que les objets peuvent être tenus à la surface du liquide par la tension superficielle de ce liquide, le film de particules modifiant la tension superficielle du liquide pouvant alors contribuer, dans une certaine mesure, à la tenue de ces objets.

Plus précisément, les particules enfoncées 4 situées sous chaque objet 50 définissent alors une rupture de niveau 52 avec les autres particules environnantes 4. Ce sont alors ces mêmes particules environnantes qui enserrent la périphérie de chaque objet 50, permettant ainsi de les maintenir en position les uns par rapport aux autres, ainsi que par rapport à la structure fixe de la zone de transfert.

Chaque rupture de niveau 52 est de préférence inférieure au diamètre des particules 4, de sorte que les particules enfoncées 4 soient également retenues et maintenues par les particules environnantes.

La mise en position des premiers objets, ainsi que des suivants, s'effectue préférentiellement sans arrêter le flux de particules provenant de la rampe 12, bien qu'il puisse en être autrement, sans sortir du cadre de l'invention.

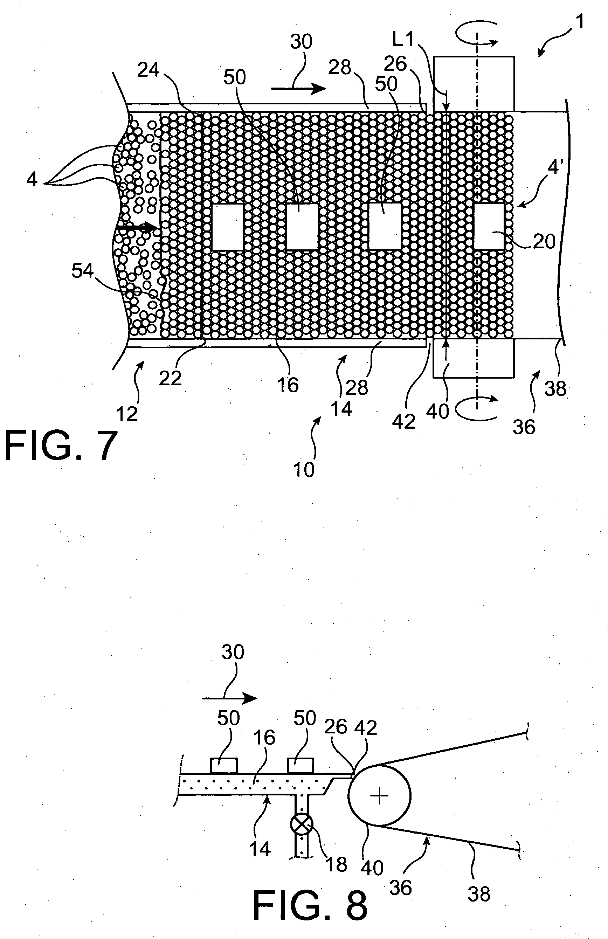

La figure 7 montre l'état de l'installation après le déclenchement du mouvement du substrat 38, initié dès que le front 54 a atteint le niveau requis représenté sur la figure 5. Le film de particules et les objets portés, maintenus et convoyés par ce dernier, se déposent alors sur le substrat 38 en empruntant le pont capillaire 42, à la manière de celle décrite dans le document CA 2 695 449. Comme évoqué ci-dessus, la largeur de ce film 4' intégrant les objets 50 correspond à la largeur L1 de la sortie 26, même si une largeur inférieure peut être adoptée, sans sortir du cadre de l'invention.

De façon encore plus préférée, le substrat est directement au contact de la sortie des particules.

Les particules ordonnées 4 recouvrant toute la surface du liquide porteur 16 présent dans la zone de transfert, l'ordonnancement est ainsi conservé jusqu'au moment du dépôt à la sortie 26 de la zone 14. La conservation de cet ordonnancement assure le maintien d'un positionnement relatif précis entre les objets 50, ainsi qu'une position précise par rapport aux rebords latéraux fixes 28, jusqu'à ce que ces objets 50 soient déposés/transférés sur le substrat avec les particules 4.

Pour faciliter le dépôt et l'adhérence des particules 4 et des objets 50 sur le substrat, de préférence réalisé en polymère, il est prévu un recuit thermique postérieurement au transfert. Ce recuit thermique est par exemple réalisé à 80°C, en utilisant un film mat de laminage basse température à base de polyester, par exemple commercialisé sous la référence PERFEX-MATT™, d'épaisseur 125µm.

L'avantage d'un tel film en tant que substrat est que l'une de ses faces devient collante à la température de l'ordre de 80°C, ce qui permet de faciliter l'adhérence des particules 4 et des objets 50 sur celle-ci. Cette température étant relativement basse par rapport aux températures d'élaboration des objets visés par l'invention comme les puces en silicium ou les cellules photovoltaïques, la fixation de ces objets peut s'effectuer sans détérioration.

Plus précisément, à cette température, les particules 4 s'enfoncent dans le film ramolli 38, et permettent ainsi un contact direct des objets avec le film, qui conduit à leur collage.

Alternativement, le substrat 38 peut être du type silicium, verre, ou encore film piézoélectrique.

Au cours du transfert, l'injection de particules et la vitesse de défilement du substrat sont réglées de sorte que le front de particules reste dans une position sensiblement identique. Pour ce faire, le débit de particules peut être de l'ordre de 0,1 ml/min à plusieurs ml/min, tandis que la vitesse linéaire du substrat 38, également dénommée vitesse de tirage, peut être de l'ordre de quelques mm/min à plusieurs centaines de mm/min. Bien entendu, les objets 50 sont déposés au fur et à mesure sur le film de particules ordonnées 4, dans la zone de transfert 14, avant que l'ensemble formé par ces éléments n'atteigne le substrat 38 sur lequel il est ensuite déposé/transféré.

Les objets à transférer peuvent être de différentes sortes, en fonction des applications désirées. Préférentiellement, chaque objet 50 présente une grande dimension supérieure à 0,2 cm et inférieure ou égale à L1, c'est-à-dire proche 30 cm. L'épaisseur est comprise entre une dizaine de micromètres et plusieurs dizaines de millimètres.

Certains types d'objets à transférer comme les cellules solaires, micro-batteries et composants organiques ont une forme simple de carré, de rectangle, ou encore de disque, avec une faible épaisseur, et une superficie de l'ordre de 0,1 à 100 cm².

Ces composants peuvent comporter des plots ou pinoches sur la face en contact avec le liquide pour procéder à leur connectique. D'autres types objets, visant par exemple la détection d'éléments, la génération d'énergie ou encore le transport de l'information, peuvent avoir des formes complexes, par exemple des parties courbés ou en spirale.

Par ailleurs, le rapport entre la grande dimension des particules 4 et celle des objets 50 à transférer est préférentiellement compris entre 10⁴ et 10⁸. En effet, la grande dimension des particules est par exemple de l'ordre de 1 nm à 500 µm, tandis que les objets convoyés 50 peuvent présenter une grande dimension allant jusqu'à environ 30 cm.

De préférence, la face de chaque objet 50 au contact du liquide porteur est à caractère hydrophobe, mais il est également possible de prévoir un agencement de parties hydrophiles et hydrophobes au niveau de cette face. Comme évoqué ci-dessus, la tension superficielle du liquide porteur joue aussi un rôle important dans la flottaison de ces objets.

Le tableau ci-dessous recense quelques exemples préférés pour ces objets 50.

| **Nature** | **Dimensions** | **Domaine d'application** |
|---|---|---|
| Polyéthylène téréphtalate (PET) avec couche d'or structurée en surface | PET : 3x4cm² ; épaisseur 250µm ; PET : 1,5x0,9cm² ; épaisseur 250µm, Au : épaisseur 30nm | Electronique organique |
| Verre avec cellule PV (?) en surface | 25x25mm²; épaisseur 1,08mm | Cellule Photovoltaïque |
| Puce en silicium | 3x3cm² ; épaisseur 500µm | Electronique |
| | 1x1cm² ; épaisseur 500µm | |
| Micro-batterie sur silicium | 1x1cm² ; épaisseur 500µm | Stockage énergie |
| Matériau métallique bilame (ex. : zinc/cuivre) | 3,5x2cm² ; épaisseur 140µm | Thermique, capteurs |
| | 5x1,6cm² ; épaisseur 200µm | |
| | 7x1,6cm² ; épaisseur 200µm | |

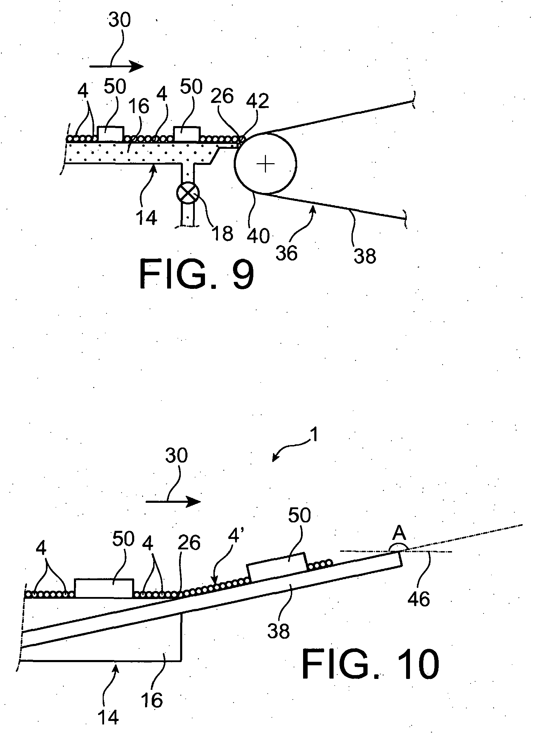

En référence à présent aux figures 8 et 9, il est schématisé des étapes d'un procédé de transfert d'objets selon un autre mode de réalisation.

Ce procédé se distingue du précédent par le fait que les objets 50 ne sont pas posés sur le film de particules ordonnées 4, mais flottent sur le liquide porteur 16 en étant entourés par ce même film. Ici, les objets 50 sont alors préférentiellement placés sur le liquide porteur avant la formation du film compact de particules, qui se constitue ensuite autour de ces objets de manière à les maintenir en position en les enserrant à leur périphérie. Les objets présentent ainsi une surface inférieure directement en contact avec le liquide porteur. Dans ce mode de réalisation, c'est également le film de particules ordonnées qui permet de maintenir les objets en position et de les transporter de façon ordonnée jusqu'au substrat sur lequel ces derniers doivent être déposés.

Les autres étapes du procédé sont analogues à celles décrites pour le procédé précédent.

Enfin, la figure 10 représente une autre installation 1 de transfert d'objet, qui se différencie de la précédente essentiellement par le fait que le substrat en défilement 38 est rigide. Sur cette figure, les éléments portant des références identiques à celles portées sur des éléments des figures précédentes correspondent à des éléments identiques ou similaires.

Comme évoqué ci-dessus, plusieurs solutions sont possibles pour le dépôt des objets 50. Parmi les solutions préférées, il existe celle consistant à prévoir un ou plusieurs convoyeurs pour le transport de ces objets vers la zone de transfert.

Chaque convoyeur 60 est de préférence parallèle à la rampe 12, comme cela est montré sur la figure 11a. Le convoyeur 60, fixe ou mobile, peut être réalisé de toute manière réputée appropriée par l'homme du métier, typiquement à l'aide d'un ruban ou d'une succession de rouleaux. Les objets sont ainsi transportés et déposés par le convoyeur 60 à une cadence déterminée en fonction de l'agencement désiré de ces objets par rapport au film de particules 4.

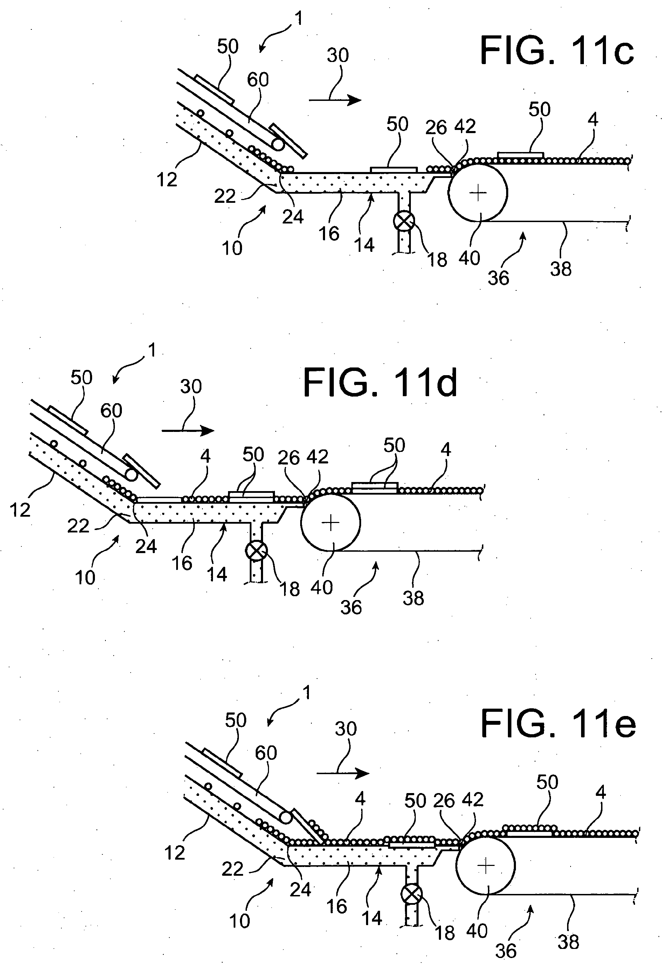

D'ailleurs, avec cette technique, il est non seulement possible de déposer les objets 50 sur le film de particules 4 comme montré sur la figure 11a, mais également directement sur le liquide porteur 16 avant que les particules 4 ne viennent les entourer dans la zone de transfert 14, comme cela a été schématisé sur la figure 11c. Alternativement, il est aussi possible de déposer les objets 50 sur d'autres objets similaires, comme cela a été représenté sur les figures 11b et 11d. Sur la figure 11b, les objets 50 sont déposés sur d'autres objets 50 eux-mêmes posés sur le film de particules, tandis que sur l'exemple de la figure 11d, les objets 50 sont déposés sur d'autres objets 50 déjà intégrés au film de particules 4.

Enfin, parmi ces solutions de dépôt d'objets dites « au déroulé », il possible de faire en sorte que les objets 50 s'échappant du convoyeur 60 perforent le film de manière à se glisser sous ce dernier, comme montré sur la figure 11e. Après stabilisation, chaque objet 50 flottant sur le liquide porteur 16 est bien maintenu par les particules 4 du film qui l'entoure,

Associé au convoyeur 60, un module de vision (non représenté) avec logiciel de traitement d'image peut suivre en temps réel le déplacement des objets sur le convoyeur 60, le transfert de ces éléments, et enfin le tirage de l'ensemble sur le substrat. Ce module de vision peut également calculer les écarts géométriques entre les objets déposés sur le film compact, et éventuellement comparer ces écarts à un schéma théorique préprogrammé, de manière à valider le bon positionnement des objets déposés.

Bien entendu, diverses modifications peuvent être apportées par l'homme du métier à l'invention qui vient d'être décrite, uniquement à titre d'exemples non limitatifs.

## Revendications

1. Procédé de transfert d'objets (50) sur un substrat (38), de préférence en défilement, **caractérisé en ce qu'**il est mis en oeuvre à l'aide d'une zone de transfert (14) comprenant une entrée (22) et une sortie (26) espacées l'une de l'autre par deux rebords latéraux (28) en regard, et retenant un liquide porteur (16) formant convoyeur, lesdits objets (50) étant maintenus par un film compact de particules (4) flottant sur le liquide porteur (16) de cette zone de transfert, au sein de laquelle lesdits objets (50) sont déplacés avec ledit film de particules (4) de manière à être transférés sur le substrat (38) lorsqu'ils atteignent la sortie (26).

2. Procédé selon la revendication 1, **caractérisé en ce qu'**au moins l'un des objets à transférer (50) est placé dans la zone de transfert (14), en flottaison sur le liquide porteur (16) formant convoyeur, de manière à être entouré par le film de particules.

3. Procédé selon la revendication 1, **caractérisé en ce qu'**au moins l'un des objets (50) à transférer est placé dans la zone de transfert (14) sur le film compact de particules (4) préalablement formé, de manière à créer, dans le liquide porteur (16), un enfoncement des particules qui le supportent.

4. Procédé selon l'une quelconque des revendications précédentes, **caractérisé en ce que** le rapport entre la grande dimension des particules (4) et celle des objets (50) à transférer est compris entre 10⁴ et 10⁸.

5. Procédé selon l'une quelconque des revendications précédentes, **caractérisé en ce que** les particules (4) sont des billes de silice d'environ 1 µm de diamètre.

6. Procédé selon l'une quelconque des revendications précédentes, **caractérisé en ce que** chaque objet (50) à transférer présente une grande dimension supérieure à 0,2 cm.

7. Procédé selon l'une quelconque des revendications précédentes, **caractérisé en ce que** chaque objet (50) présente au moins une partie à caractère hydrophobe.

8. Procédé selon l'une quelconque des revendications précédentes, **caractérisé en ce que** chaque objet (50) à transférer est un élément pris parmi le groupe des puces en silicium, des micro-batteries, des composants de l'électronique organique, des éléments métalliques, des cellules photovoltaïques, des piles et micro-piles.

9. Procédé selon l'une quelconque des revendications précédentes, **caractérisé en ce que** ledit film de particules ordonnées (4) flottant sur le liquide porteur (16) est obtenu par compression, et/ou interaction dipôle-dipôle, et/ou par champ magnétique.

10. Procédé selon l'une quelconque des revendications précédentes, **caractérisé en ce qu'**il met en oeuvre une rampe inclinée (12) de circulation des particules, rattachée à ladite entrée de la zone de transfert, et sur laquelle ledit liquide porteur (16) est également destiné à circuler.

11. Procédé selon l'une quelconque des revendications précédentes, **caractérisé en ce que** postérieurement au transfert des particules (4) et des objets (50) sur le substrat, il intègre une étape de recuit thermique pour faciliter le dépôt et l'adhérence de ces particules (4) et objets (50) sur le substrat.

12. Procédé selon l'une quelconque des revendications précédentes, **caractérisé en ce que** le dépôt objets (50) dans la zone de transfert (14) s'effectue à l'aide d'un ou plusieurs convoyeurs (60).

## Patentansprüche

1. Verfahren zum Transferieren von Objekten (50) auf ein Substrat (38), vorzugsweise im Durchlauf, **dadurch gekennzeichnet, dass** es mit Hilfe einer Transferzone (14) durchgeführt wird, die einen Eingang (22) und einen Ausgang (26) umfasst, die voneinander durch zwei gegenüberliegende laterale Ränder (28) beabstandet sind, und die eine Trägerflüssigkeit (16) enthält, die einen Förderer bildet, wobei die Objekte (50) durch einen kompakten Film von Partikeln (4) gehalten werden, die auf der Trägerflüssigkeit (16) dieser Transferzone treiben, innerhalb der die Objekte (50) zusammen mit dem Partikelfilm (4) derart verlagert werden, dass sie auf das Substrat (38) transferiert werden, wenn sie den Ausgang (26) erreichen.

2. Verfahren nach Anspruch 1, **dadurch gekennzeichnet, dass** wenigstens eines der zu transferierenden Objekte (50) in der Transferzone (14) auf der Trägerflüssigkeit (16) treibend platziert wird, die den Förderer bildet, derart, dass es von dem Partikelfilm umgeben wird.

3. Verfahren nach Anspruch 1, **dadurch gekennzeichnet, dass** wenigstens eines der zu transferierenden Objekte (50) in der Transferzone (14) auf dem zuvor gebildeten kompakten Partikelfilm (4) derart platziert wird, dass in der Trägerflüssigkeit (16) eine Einsenkung der Partikel erzeugt wird, die es stützen.

4. Verfahren nach einem der vorhergehenden Ansprüche, **dadurch gekennzeichnet, dass** das Verhältnis zwischen der großen Abmessung der Partikel (4) und jener der zu transferierenden Objekte (50) zwischen 10⁴ und 10⁸ enthalten ist.

5. Verfahren nach einem der vorhergehenden Ansprüche, **dadurch gekennzeichnet, dass** die Partikel (4) Silicakugeln mit einem Durchmesser von ungefähr 1 µm sind.

6. Verfahren nach einem der vorhergehenden Ansprüche, **dadurch gekennzeichnet, dass** jedes zu transferierende Objekt (50) eine große Abmessung von mehr als 0,2 cm aufweist.

7. Verfahren nach einem der vorhergehenden Ansprüche, **dadurch gekennzeichnet, dass** jedes Objekt (50) wenigstens einen Teil mit hydrophoben Eigenschaften aufweist.

8. Verfahren nach einem der vorhergehenden Ansprüche, **dadurch gekennzeichnet, dass** jedes zu transferierende Objekt (50) ein Element ist ausgewählt aus der Gruppe von Siliciumchips, Microbatterien, Komponenten der organischen Elektronik, metallische Elemente, photovoltaische Zellen, sonstige Zellen und Micro-Zellen.

9. Verfahren nach einem der vorhergehenden Ansprüche, **dadurch gekennzeichnet, dass** der auf der Trägerflüssigkeit (16) treibende Film von geordneten Partikeln (4) durch Kompression und/oder Dipol-Dipol-Wechselwirkung und/oder durch ein Magnetfeld erhalten wird.

10. Verfahren nach einem der vorhergehenden Ansprüche, **dadurch gekennzeichnet, dass** es eine geneigte Partikelzirkulationsrampe (12) verwendet, die am Eingang der Transferzone angebracht ist, wobei auch die Trägerflüssigkeit (16) dazu ausgelegt ist, auf ihr zu zirkulieren.

11. Verfahren nach einem der vorhergehenden Ansprüche, **dadurch gekennzeichnet, dass** es nach dem Transfer der Partikel (4) und der Objekte (50) auf das Substrat einen Schritt des thermischen Glühens enthält, um die Aufbringung und das Anhaften dieser Partikel (4) und Objekte (50) auf dem Substrat zu erleichtern.

12. Verfahren nach einem der vorhergehenden Ansprüche, **dadurch gekennzeichnet, dass** das Aufbringen der Objekte (50) in der Transferzone (14) mit Hilfe eines oder mehrerer Förderer (60) erfolgt.

## Claims

1. Method for transferring objects (50) onto a substrate (38), preferably moving, **characterized in that** it is implemented by means of a transfer area (14) comprising an inlet (22) and an outlet (26) spaced apart from one another by two lateral edges (28) opposite one another, and holding a carrier liquid (16) forming a conveyor, said objects (50) being held by a compact film of particles (4) floating on the carrier liquid (16) of this transfer area, in which said objects (50) are moved with said particle film (4) so as to be transferred onto the substrate (38) when they reach the outlet (26).

2. Method according to claim 1, **characterized in that** at least one of the objects (50) to be transferred is placed in the transfer area (14), floating on the carrier liquid (16) forming a conveyor, so as to be surrounded by the particle film.

3. Method according to claim 1, **characterized in that** at least one of the objects (50) to be transferred is placed in the transfer area (14) on the compact particle film (4) previously formed, so as to create, in the carrier liquid (16), a compression of particles supporting it.

4. Method according to any one of the previous claims, **characterized in that** the ratio between the large dimension of the particles (4) and that of the objects (50) to be transferred is between 10⁴ and 10⁸.

5. Method according to any one of the previous claims, **characterized in that** the particles (4) are silica beads around 1 µm in diameter.

6. Method according to any one of the previous claims, **characterized in that** each object (50) to be transferred has a large dimension greater than 0.2 cm.

7. Method according to any one of the previous claims, **characterized in that** each object (50) has at least one hydrophobic portion.

8. Method according to any one of the previous claims, **characterized in that** each object (50) to be transferred is an element from the group of silicon chips, microbatteries, organic electronic components, metal elements, photovoltaic cells, cells and microcells.

9. Method according to any one of the previous claims, **characterized in that** said film of ordered particles (4) floating on the carrier liquid (16) is obtained by compression, and/or dipole-dipole interaction and/or by magnetic field.

10. Method according to any one of the previous claims, **characterized in that** it implements an inclined ramp (12) for particle circulation, attached to said inlet of the transfer area, and on which said carrier liquid (16) is also intended to circulate.

11. Method according to any one of the previous claims, **characterized in that**, after the particles (4) and objects (50) have been transferred onto the substrate, it comprises a thermal anneal step for facilitating the deposition and adhesion of these particles (4) and objects (50) on the substrate.

12. Method according to any one of the previous claims, **characterized in that** the deposition of objects (50) in the transfer area (14) is performed by means of one or more conveyors (60).
